# EUROPEAN PATENT APPLICATION

(11) **EP 4 628 951 A1**
(43) Date of publication of application: **08.10.2025**
(21) Application number: 25167514.6
(22) Date of filing: 31.03.2025
(51) Int. Cl.: G02B 6/124, G02B 6/12

(54) **VCSEL/PCSEL LIGHT COUPLING INTO THE MULTILAYER WAVEGUIDE FOR SHORT REACH OPTICAL COMMUNICATION**

(30) Priority: 03.04.2024 US 202463574118 P; 19.03.2025 US 202519084177
(71) Applicant: II-VI Delaware, Inc., Wilmington, DE 19890 (US)
(72) Inventor: TATARCZAK, Anna, Wilmington, 19890 (US); KOCOT, Christopher, Wilmington, 19890 (US); IAZIKOV, Dmitri, Wilmington, 19890 (US); HOSER, Mirko, Wilmington, 19890 (US); NELSON, Stephen, Wilmington, 19890 (US); CHEN, Young-Kai, Wilmington, 19890 (US); ENG, Julie, Wilmington, 19890 (US)
(74) Representative: Schmidt, Christian

(57) **Abstract**

This disclosure describes an optical communication system for coupling light, via VCSEL or PCSEL, into a multilayer waveguide. The optical communication system comprises a plurality of emitters, a semi-insulating (SI) substrate, a plurality of electrical contacts, a plurality of waveguides, and a diffractive optical coupling system. The SI substrate supports the plurality of emitters. The plurality of electrical contacts are configured to individually modulate each emitter. The plurality of waveguides and the plurality of emitters are separated by an air gap. The diffractive optical coupling system is configured to direct emitted light from the plurality of emitters into the waveguides.

## Description

### CROSS REFERENCE TO RELATED APPLICATIONS

This application claims priority to and the benefit of U.S. Provisional Patent Application No. 63/574,118 entitled "VCSEL/PCSEL LIGHT COUPLING INTO THE MULTILAYER WAVEGUIDE FOR SHORT REACH OPTICAL COMMUNICATION" filed April 3, 2024, which is hereby incorporated herein by reference in its entirety.

### BACKGROUND

Limitations and disadvantages of traditional systems and methods for light coupling will become apparent to one of skill in the art, through comparison of such approaches with some aspects of the present method and system set forth in the remainder of this disclosure with reference to the drawings.

### BRIEF SUMMARY

Systems and methods are provided for VCSEL/PCSEL light coupling into the multilayer waveguide for short reach optical communication, substantially as illustrated by and/or described in connection with at least one of the figures, as set forth more completely in the claims.

### BRIEF DESCRIPTION OF THE DRAWINGS

FIG. 1 illustrates a first example side view of a bottom emitting VCSEL/PCSEL, in accordance with various example implementations of this disclosure.
FIG. 2 illustrates a second example side view of a bottom emitting VCSEL/PCSEL, in accordance with various example implementations of this disclosure.
FIG. 3 illustrates a third example side view of a bottom emitting VCSEL/PCSEL, in accordance with various example implementations of this disclosure.
FIG. 4 illustrates an example top view of a bottom emitting VCSEL/PCSEL, in accordance with various example implementations of this disclosure.
FIG. 5 illustrates a first example side view of transmitter and receiver, in accordance with various example implementations of this disclosure.
FIG. 6 illustrates a second example side view of transmitter and receiver, in accordance with various example implementations of this disclosure.
FIG. 7 illustrates an example side view of a PD/TIA array receiver, in accordance with various example implementations of this disclosure.
FIG. 8 illustrates an example waveguide interposer coupled to a transmitter and receiver, in accordance with various example implementations of this disclosure.

### DETAILED DESCRIPTION

This disclosure relates to laser-based optical communication systems utilizing an array of lasers for data transmission over waveguides. The following discussion provides various examples of lasers, for example, vertical-cavity surface-emitting lasers (VCSELs) or photonic crystal surface-emitting lasers (PCSELs). Such examples are non-limiting, and the scope of the appended claims should not be limited to the particular examples disclosed. In the following discussion, the terms "example" and "e.g." are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The terms "comprises," "comprising," "includes," and/or "including," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Existing optical communication technologies face challenges in compactly integrating and efficiently coupling vertically emitting light sources to waveguides located at multiple levels. The present disclosure addresses these challenges by providing a novel assembly design that integrates an array of individually modulated emitters with waveguides to enable efficient data communication. The disclosed assembly minimizes emitter pitch through the use of a shared semi-insulating (SI) substrate and a current spreading layer. Light from each individually modulated emitter is separately launched into either a channel or slab waveguide, which may be distributed horizontally in a single layer and/or vertically stacked.

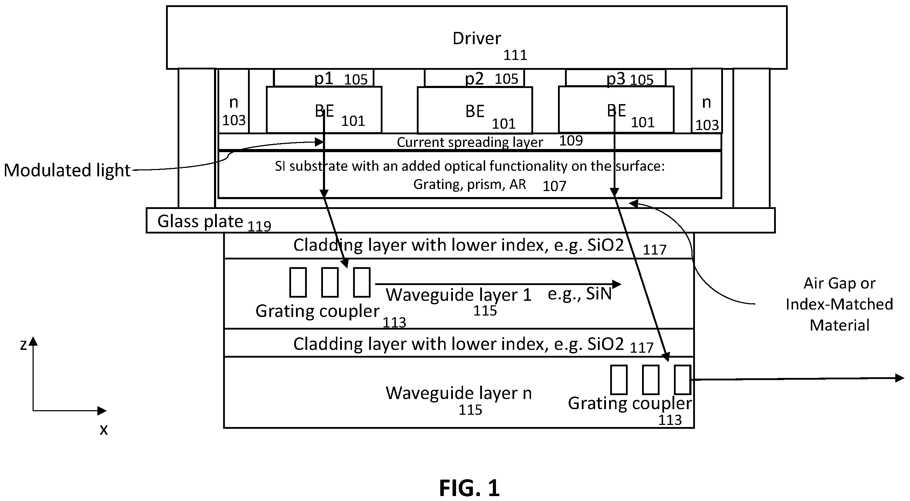

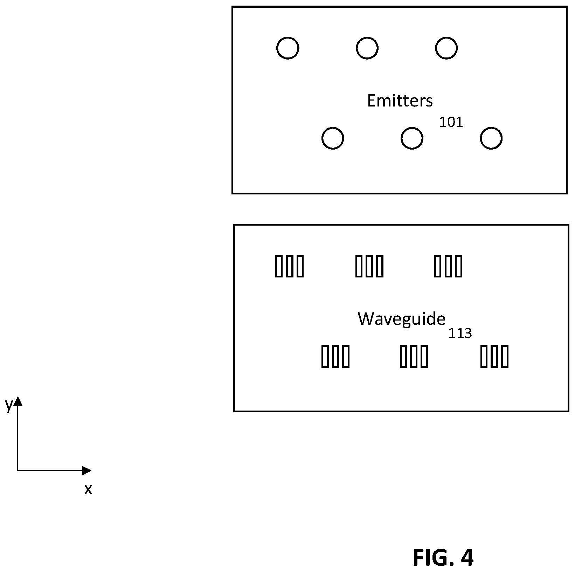

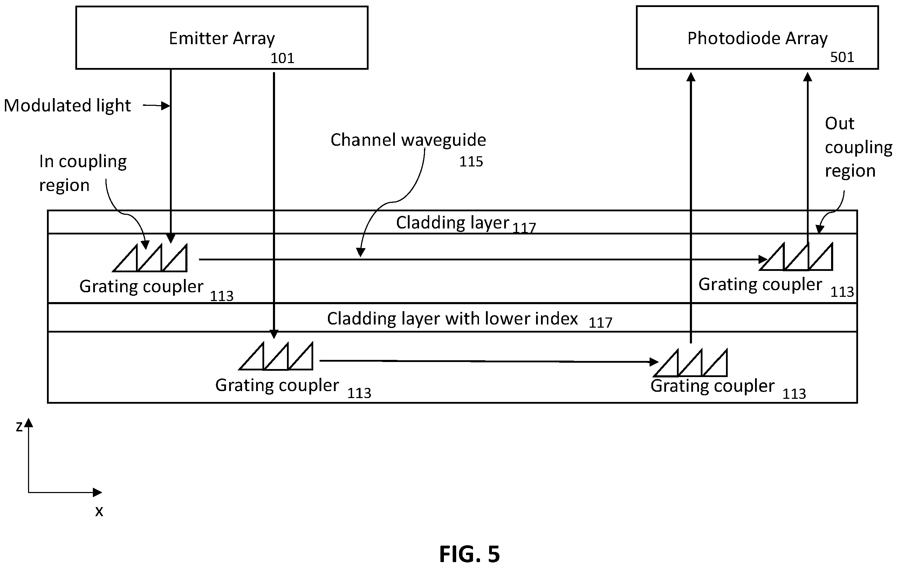

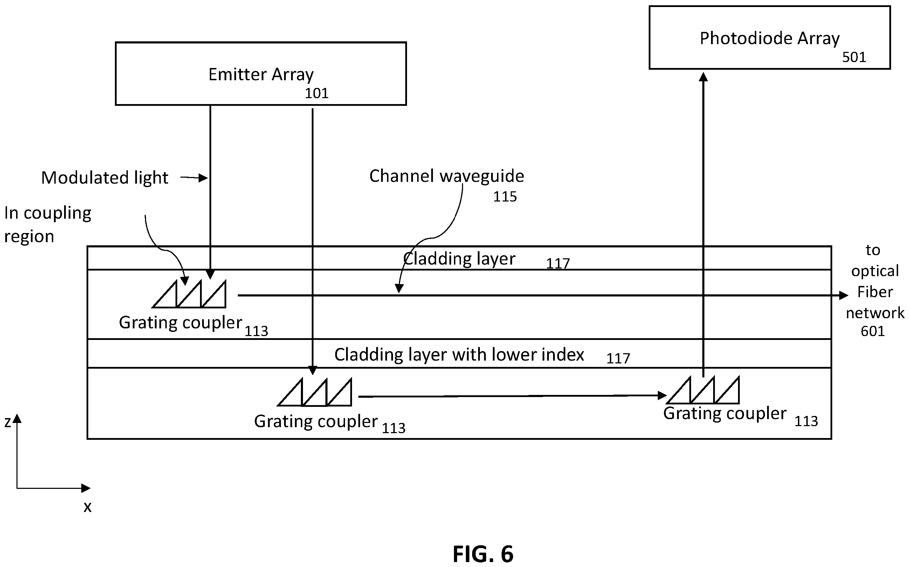

FIGS. 1-3 illustrate example side views of bottom-emitting vertical-cavity surface-emitting laser (VCSEL) or photonic-crystal surface-emitting laser (PCSEL) configurations. FIG. 4 provides a top view of such example implementations. FIGS. 5 and 6 illustrate example side views of a transmitter and receiver configuration, in accordance with various example implementations of this disclosure.

The assembly comprises a plurality of backside emitters (BEs) 101, electrical contacts (n 103 and p1, p2, p3 105), and a semi-insulating (SI) substrate 107. The plurality of BEs 101 may be arranged as an array of VCSELs or PCSELs. Each emitter 101 in the array may be individually modulated via separate electrical contacts (p1, p2, p3 105). The emitters 101 may share a common current spreading layer 109 and n-type electrical contacts 103 that reduce emitter-to-emitter pitch. The polarity of the electrical contacts may be configured according to the driver 111 and epitaxial design.

The plurality of BEs 101 may comprise emitters with identical or different wavelengths. For an SI substrate 107, wavelengths may be equal to or greater than 940 nm to ensure transparency. Alternative substrate materials may be used to support a broader range of wavelengths.

Polarization control of emitted light may be achieved using gratings located at the device output or within the device structure. The active laser regions, where light originates, may be positioned above or below the current spreading layer. Drivers 111 may be flip-chipped on top of the emitter array 101 or positioned adjacently. Although the examples provide focus on bottom-emitting configurations, top-emitting variations may be implemented similarly.

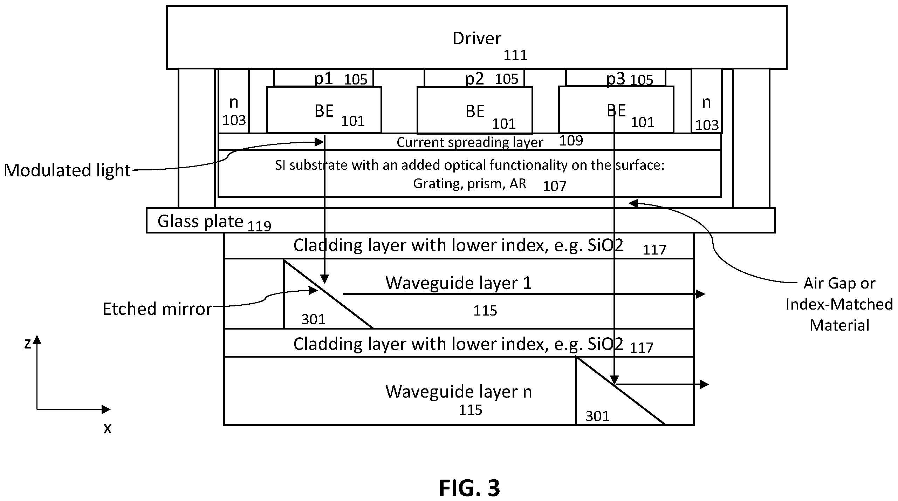

Waveguides 115 may be co-integrated directly with the emitter devices, separated by a spacer comprising an index-matched material, or set across an air gap. Light coupling into the waveguide 115 may be facilitated through grating couplers 113 (as shown in FIGS. 1, 2, and 5) or etched mirrors 301 (as shown in FIG. 3) embedded in the waveguide layer 115. A prism or grating may be integrated on the substrate surface of the emitter array 107 (as shown in FIGS. 1-3) to redirect the beam towards a vertical rectangular grating coupler 113 for optimal waveguide coupling.

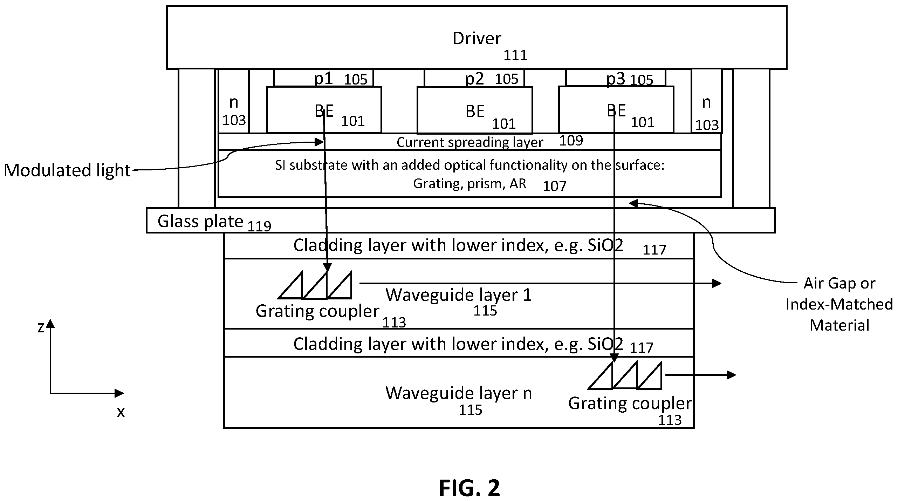

As shown in FIG. 2, the grating coupler 113 may be implemented as a second-order grating with a blazed profile. Effective refractive index binary profile blazing, or other optimized morphology, may enhance coupling efficiency. Grating periods may be spatially adjusted (i.e., chirped) to compensate for varying incident angles due to beam divergence and ensure efficient coupling into the waveguide layer.

After passing through the grating coupler 113 (FIGS. 1, 2, and 5) or reflected by the mirror 301 (FIG. 3), the optical beam may be tapered and directed into a channel waveguide that may connect to a wavelength multiplexer or be routed to another waveguide segment. The plurality of waveguides may comprise an adiabatic taper configured to control beam expansion and out-coupling. The beam may also propagate in a slab waveguide.

Focusing or collimating functionalities may be incorporated using diffractive, refractive, and/or Fresnel lenses. Diffractive optical couplers may utilize chirped periods or curved contours to optimize coupling efficiency and divergence management. Such functionalities may be integrated into the emitter array's bottom surface or within the grating coupler 113. Anti-reflective coatings may be applied to optical elements to mitigate back-reflections into the light source.

Silicon nitride (SiN) may be used as a waveguide material, while silicon dioxide (SiO₂) may serve as a cladding layer 117 to achieve sufficient refractive index contrast for effective mode confinement. Multi-layered waveguides 115 with interposed cladding layers 117 may also be utilized. The plurality of waveguides 115 may be configured in a symmetrical receiver-side design.

As shown in FIG. 5, the channel waveguide is positioned in the in-coupling region, where an adiabatic taper may be used for beam expansion and out-coupling. A symmetrical receiver-side design employing out-couplers to extract light from the waveguide may be implemented. The size of the out-coupling region may be optimized to achieve collimation of the extracted light, constrained by the diffraction limit of the operating wavelength and aperture size.

If multiple input wavelengths are used, they may co-propagate within the channel or slab waveguide. A grating coupler may be designed to selectively in-couple or out-couple specific wavelengths without affecting others propagating in the waveguide.

In addition to silicon nitride, other suitable waveguide materials include: silicon oxycarbide (SiOC) with a refractive index up to 2.3, aluminum nitride (AIN), aluminum oxynitride (AlON), amorphous silicon (a-Si), polysilicon, lithium niobate (LiNbO₃) and gallium nitride (GaN). The key requirement for waveguide materials is a high refractive index contrast while maintaining compatibility with a glass substrate 119 through appropriate cladding layers 117.

Each emitter 101 may be individually addressable by the driver 111 via an associated P-contact 105 (P₁, P₂, P₃, etc.). Typically, N-contacts 103 are shared, while P-contacts 105 are individually driven, although this configuration may be reversed. Drivers 111 may enable sub-millimeter pitch densities. Grating couplers 113, mirrors 301 and other waveguide features may be fabricated using lithography, ensuring precise alignment through lithographic mask design. Alignment to the substrate 107 and emitters 101 may be achieved via reference alignment marks. Compatibility with the glass plate 119 may be achieved through optimized positioning and patterning. Fabricated mirrors 301 may comprise turning mirrors (e.g., 45° or 90° reflectors) or metamaterials.

Thermal constraints primarily arise from heat dissipation through the driver 111 and substrate 107. While current densities in data communication applications are not excessively high, an additional thermal spreading layer may be introduced under the silicon substrate if necessary. Electrical constraints are determined by the minimum pitch supported by the driver and interconnects, with copper pillars or other bonding techniques imposing a lower bound on emitter spacing.

Optical losses at waveguide coupling points are minimized through inverse design techniques that optimize the topology and geometry of coupling structures. Loss may be mitigated by designing each of the mirrors 301, gratings 113 and metamaterials for reduced optical loss. A transimpedance amplifier (TIA) may be integrated with the photodetector 501 at the receiving end.

The divergence angle may impact coupling efficiency. An example divergence angle may be associated with a numerical aperture (NA) value between 0.14 and 0.25. A smaller divergence angle within the waveguide material may allow for tighter emitter spacing without beam overlap. Additional lensing or focusing optics may be integrated at the substrate or within the grating coupler/metasurface.

As shown in FIG. 6, the system may couple into an optical fiber network 601 via grating couplers 113. The system may also integrate with photonic integrated circuits (PICs), where the glass plate 119 serves as a photonic platform. Wavelength Division Multiplexing (WDM) may be utilized to combine multiple emitters 101 into a single waveguide 115 and/or fiber 601.

Bottom-emitting designs enable efficient spatial integration by placing electrical contacts beneath the emitter, allowing for tighter emitter density. In contrast, top-emitting designs require lateral contact placement, which reduces emitter density. High-density emitter arrays may achieve pitches as small as 10 microns, enabling compact and efficient optical communication systems.

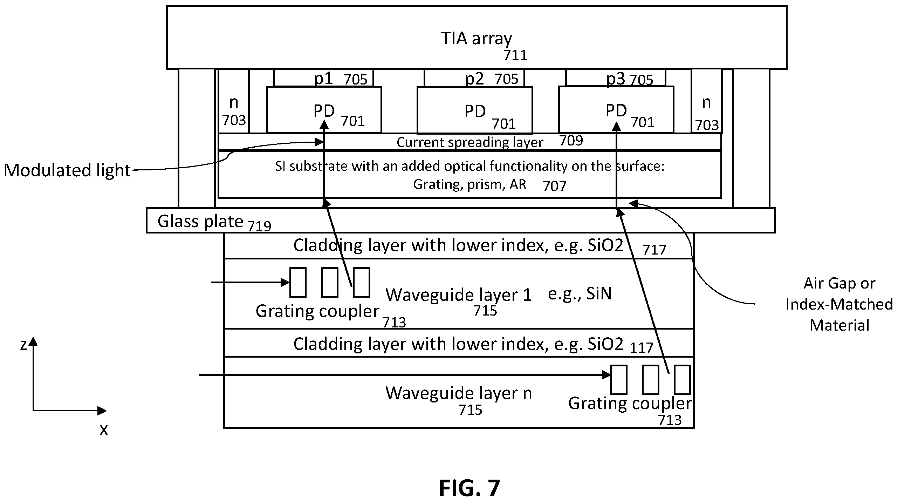

FIG. 7 illustrates an example side view of a PD/TIA array receiver, in accordance with various example implementations of this disclosure.

The assembly comprises a plurality of photodetectors (PDs) 701, electrical contacts (n 703 and p1, p2, p3 705), and a semi-insulating (SI) substrate 707. The plurality of PDs 701 may be arranged as an array. Each PD 701 in the array may be individually coupled to a separate electrical contact (p1, p2, or p3 705). The PDs 701 may share a common current spreading layer 709 and n-type electrical contacts 703 that reduce detector-to-detector pitch. The polarity of the electrical contacts may be configured according to the driver 111 and epitaxial design.

The plurality of PDs 701 may be identical or may be differentiated by wavelength. For a SI substrate 707, wavelengths may be equal to or greater than 940 nm to ensure transparency. Alternative substrate materials may be used to support a broader range of wavelengths.

Polarization of received light may be achieved using gratings located at the device input or within the device structure. The regions, where light is received, may be positioned above or below the current spreading layer. The TIA array architecture 711 may be flip-chipped on top of the PD array 701 or positioned adjacently. Although the examples provide focus on bottom-emitting configurations, top-emitting variations may be implemented similarly.

Waveguides 715 may be co-integrated directly with the emitter devices, separated by a spacer comprising an index-matched material, or set across an air gap. Light coupling into the waveguide 715 may be facilitated through grating couplers 713 (similar to those as shown in FIGS. 1, 2, and 5) or etched mirrors (similar to those as shown in FIG. 3) embedded in the waveguide layer 715. A prism or grating may be integrated on the substrate surface 707 of the PD array 701 to redirect the beam towards a vertical rectangular grating coupler 713 for optimal waveguide coupling.

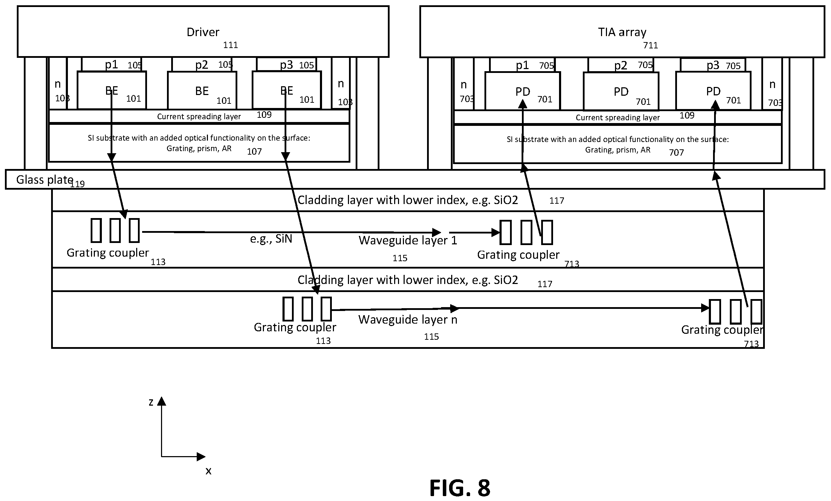

FIG. 8 illustrates an example waveguide interposer coupled to a transmitter and receiver, in accordance with various example implementations of this disclosure. FIG. 8 illustrates that the VCSEL/driver array (of FIGs. 1-3) and the PD/TIA array (of FIG. 7) may be located on a common waveguide interposer comprising the plurality of waveguides 115, the plurality of cladding layers 117, and the glass plate 119.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. An optical communication assembly, comprising:
a substrate;
a plurality of backside emitters (BEs) positioned on the substrate;
a current spreading layer shared by the plurality of BEs;
a plurality of individually addressable electrical contacts configured to modulate each BE, of the plurality of BEs, separately;
a plurality of waveguides configured to receive light emitted by the plurality of BEs; and
one or more coupling elements configured to direct light from the plurality of BEs into the plurality of waveguides.

2. The optical communication assembly of claim 1, wherein the one or more coupling elements comprise at least one of a grating coupler and an etched mirror.

3. The optical communication assembly of claim 1, wherein each of the plurality of waveguides comprises silicon nitride (SiN) and a silicon dioxide (SiO₂) cladding layer.

4. The optical communication assembly of claim 1, wherein anti-reflective features are integrated into the one or more coupling elements.

5. The optical communication assembly of claim 1, wherein the plurality of BEs comprises at least one of a vertical-cavity surface-emitting laser (VCSEL) and a photonic-crystal surface-emitting laser (PCSEL).

6. The optical communication assembly of claim 1, wherein the plurality of waveguides are arranged as one of a single horizontal layer and a plurality of vertically stacked layers.

7. The optical communication assembly of claim 1, wherein emitted light is redirected toward a vertical rectangular grating coupler via one of a prism and a grating.

8. The optical communication assembly of claim 1, wherein:
the optical communication assembly comprises a second-order grating, and
the second-order grating comprise one of a blazed profile and a plurality of chirped grating periods.

9. The optical communication assembly of claim 1, wherein the plurality of waveguides comprises at least one of a channel waveguide and a slab waveguide.

10. The optical communication assembly of claim 1, wherein the plurality of waveguides provide wavelength multiplexing.

11. An optical waveguide system, comprising:
a plurality of emitters;
a semi-insulating (SI) substrate supporting the plurality of emitters;
a plurality of electrical contacts configured to individually modulate each emitter of the plurality of emitters;
a plurality of waveguides, wherein the plurality of waveguides and the plurality of emitters are separated by an air gap; and
a diffractive optical coupling system configured to direct emitted light from the plurality of emitters into the waveguides.

12. The system of claim 11, wherein the plurality of emitters comprises at least one of a vertical-cavity surface-emitting laser (VCSEL) and a photonic-crystal surface-emitting laser (PCSEL).

13. The system of claim 11, wherein the diffractive optical coupling system comprises chirped gratings.

14. The system of claim 11, wherein the plurality of waveguides comprises stacked waveguides with interposed cladding layers.

15. The system of claim 11, wherein the plurality of waveguides is configured to guide light into an optical multiplexer for wavelength division multiplexing.

16. The system of claim 11, wherein the diffractive optical coupling system comprises Fresnel lenses configured to collimate emitted beams.

17. The system of claim 11, wherein the plurality of waveguides are configured in a symmetrical receiver-side design.

18. The system of claim 11, wherein at least one waveguide of the plurality of waveguides is configured to allow multiple wavelengths to co-propagate.

19. The system of claim 11, wherein gratings on the plurality of emitters are configured to control polarization of the emitted light.

20. The system of claim 11, wherein the plurality of waveguides comprise an adiabatic taper configured to control beam expansion and out-coupling.
